# EUROPEAN PATENT SPECIFICATION

(11) **EP 2 840 945 B1**
(45) Date of publication and mention of the grant of the patent: **10.04.2019**
(21) Application number: 13720839.3
(22) Date of filing: 24.04.2013
(51) Int. Cl.: A47J 31/44

(54) **Combination of a device for programming a capsule to deliver a beverage and a capsule**
Kombination aus einer Vorrichtung zum Progammieren von Kapseln zur Getränkeherstellung und einer Kapsel
Combination d'un dispositif pour programmer des capsules pour préparer des boissons et d'une capsule

(30) Priority: 25.04.2012 EP 12165547
(43) Date of publication of application: 04.03.2015
(73) Proprietor: Nestec S.A., 1800 Vevey (CH)
(72) Inventor: JARISCH, Christian, 1095 Lutry (CH); AGON, Fabien Ludovic, 1807 Blonay (CH)
(74) Representative: Sacroug, Olivier
(86) International application number: PCT/EP2013/058414
(87) International publication number: WO 2013/160318

(56) References cited:
- EP-A1- 1 890 271
- WO-A1-03/005295
- WO-A1-2011/000724
- WO-A1-2012/059892

## Description

### Field of the invention

The invention pertains to the field of the beverage preparation machines, in particular using capsules containing an ingredient for preparing a beverage, such as beverage preparation machines having a brewing chamber that can be opened and closed for inserting the capsule into the chamber and/or removal of a used capsule therefrom. More particularly, the invention relates to a device for programming a user-programmable capsule, and a beverage preparation machine for preparing a beverage with a user-programmed capsule, providing a convenient and adaptable solution to automate and adapt to user's preferences the preparation of a beverage.

For the purpose of the present description, a "beverage" is meant to include any human-consumable liquid substance, such as coffee, tea, hot or cold chocolate, milk, soup, baby food or the like. A "capsule" is meant to include any pre-portioned beverage ingredient or combination of ingredients (hereafter called "ingredient") within an enclosing packaging of any suitable material such as plastic, aluminium, a recyclable and/or bio-degradable material and combinations thereof, including a soft pod or a rigid cartridge containing the ingredient.

### Technical background

Certain beverage preparation machines use capsules containing an ingredient to be extracted or to be dissolved and/or an ingredient that is stored and dosed automatically in the machine or else is added at the time of preparation of the drink. Some beverage machines possess liquid filling means that include a pump for liquid, usually water, which pumps the liquid from a source of water that is cold or indeed heated through heating means, e.g. a thermoblock or the like.

Especially in the field of coffee preparation, machines have been widely developed in which a capsule containing a beverage ingredient is inserted in a brewing device. The brewing device is tightly closed about the capsule, water is injected at the first face of the capsule, the beverage is produced in the closed volume of the capsule and a brewed beverage can be drained from a second face of the capsule and collected into a receptacle such as a cup or glass.

Brewing devices have been developed to facilitate insertion of a capsule into the chamber, for instance, by using a feeding arrangement or a motorized brewing unit. WO 01/84993 relates to a beverage machine with a movable drawer sliding horizontally to bring a capsule from a loading stated to an inserted position in a motorized brewing unit. Such machine allows automating tasks like the introduction of a capsule into the brewing unit or the preparation of a plurality of beverages. However, for triggering the preparation of the beverage, the user has still to either activate manually the movable drawer sliding and/or press a start button.

WO 03/005295 describes a food container comprising an electronic tag, for example a RFID tag, in which information about the content of the container is stored at the manufacturing plant. The information is then read and used by the product dispensing machine when processing the container.

WO 2012/059892 describes a system for monitoring and controlling modes of operation of a machine for preparing beverages by means of cartridges or capsules, where a RFID that can be read by the machine is associated with each pack of capsules.

### Summary of the invention

An object of the invention is to provide more convenience, less user's intervention and more safety in the way of inserting a capsule in the machine. Another object is to provide added value functionalities such as semi-automatic or automatic brewing modes. Another object is to control optimal conditions for preparing a beverage. Another object is to customize the preparation of a beverage according to preferences of a user without increasing complexity and harming the ergonomics of the machine. Another object is to propose flexible, modular and open systems, and to allow the use of new types of devices in the field of beverage preparation machines.

Another object of the invention is to simplify the user interface on the beverage preparation machine, for example by reducing the number of buttons, displays, etc. Another object of the invention is to allow the user customizing individually parameters for each capsule used for preparing a beverage, according to the user's own preferences. Another object is to avoid contact of the user with the machine, increasing therefore hygienic quality aspects of the system.

One or more of these objects are met by a machine according to the independent claim(s). The dependent claims further provide solutions to these objects and/or additional benefits.

The invention preferably makes use of a capsule adapted for delivering a beverage in a beverage producing device, the capsule comprising a storage having a memory space and a first communication interface configured to: write information in the memory space; and allow the reading of information stored in the memory space; for writing in the memory space user-defined parameters by a user of the beverage producing device, wherein the user-defined parameters will be used by the beverage producing device for preparing the beverage, which user-defined parameters relate to preferences of the user, whereby the user-defined parameters received on the capsule communication interface are written in the memory space and allowed to be read through the capsule communication interface.

The capsule communication interface may be arranged to allow the reading of the information stored in the memory space by sending said information upon request, or by broadcasting periodically or continuously said information.

The user-defined parameters may relate to one or any combination of the following parameters: user's preferred volume of beverage to prepare with the capsule, user's preferred temperature of beverage to prepare with the capsule, user's preferred pressure used for preparing a beverage with the capsule, user's preferred recipe used for preparing a beverage with the capsule, user's preferred ingredients used for preparing a beverage with the capsule, user's preferred additional ingredients used for preparing a beverage with the capsule, user's preferred pre-wetting setup used for preparing a beverage with the capsule.

The capsule may further comprises identification means for allowing the recognition of a type related to the capsule. For example, the identification means may comprise an element having an identifiable characteristics such spectral property, colour, electrical property, resistivity, capacitance, electromagnetic property, magnetic induced field, mechanical property, geometry, weight, identifying information, code bar, emitted or reflected signal.

The capsule communication interface is for example arranged to be accessed wirelessly. For example, the capsule communication interface comprises a RFID interface, configurable in a read mode and a write mode.

Alternatively, the capsule communication interface is arranged to be accessed by contact. For instance, the capsule communication interface may comprise an electrical and/or capacitive interface.

More particularly, according to a first aspect, the invention relates to a programming device for programming a capsule to deliver a beverage in a beverage producing device and such a capsule. The capsule comprises a storage having a memory space for storing information related to preferences of the user of the beverage producing device, and a capsule communication interface configured to: write in the memory space the information related to the preferences of the user, received on the capsule communication interface; and allow the reading of the information stored in the memory space. The programming device comprises:
- a preferences manager for accessing preferences provided by the user of the beverage producing device;
- a communication interface of the beverage producing device configured, when coupled with the capsule communication interface, to send to the capsule communication interface the preferences provided by the user of the beverage producing device.

In an embodiment, the programming device comprises a user-interface for the user to enter and/or select the preferences.

In an embodiment, the programming device may comprise an identification means for identifying the user, and for setting the preferences according to the identity of the user. For example, the programming device may store a profile for a plurality of users of the beverage machine, and comprises a login and/or password identification system for identifying the user and retrieving its stored profile comprising its own preferences.

According to a second aspect, the invention relates to a beverage preparation system comprising a combination according to the first aspect and a beverage preparation machine having an ingredient processing module for preparing a beverage with at least one ingredient supplied with a capsule as described above. The machine comprises a reader having a machine communication interface configured, when coupled with the capsule communication interface of the capsule, to read, through the capsule communication interface, the information stored in the memory space of the capsule, the ingredient processing module being configured to prepare the beverage according to the read information.

In an embodiment, the beverage preparation machine further comprises a positioner arranged to hold the capsule, a sensing arrangement adapted to detect an event related to the insertion by a user of the capsule and/or the presence of the capsule on or into the positioner; the machine being configured, upon detection of the event, to transfer the capsule to the ingredient processing module by using transfer means, and then to start the preparation of the beverage.

In an embodiment, the ingredient processing module comprises a first part and a second part which are movable relatively one another, said processing module being configurable into an opened position wherein a passage is provided between the first and second part for allowing the insertion of a capsule. The machine further comprises closing means arranged to close at least partially the passage; the machine being further configured to operate the closing means so as to open the passage upon the detection of the event.

The ingredient processing module may be configured to prepare the beverage according to default parameters if the information stored in the memory space of the capsule cannot be read or are empty, corrupted or not usable by the machine.

In an embodiment, the machine may comprise a programming device according to the first aspect.

### Brief description of the drawings

The invention will now be described with reference to the schematic drawings, wherein:
- Figure 1 is a schematic view of a beverage machine according to an embodiment;
- Figure 2 is a cross section of a capsule adapted to be used by the beverage machine to prepare a beverage;
- Figure 3a is a partial cross section perspective representation of a brewing unit of the beverage machine of figure 1 in open position;
- Figure 3b shows a partial cross section perspective representation of a closed brewing unit of the beverage machine of figure 1 in an "empty closure mode";
- Figure 3c shows a partial cross section perspective representation of a closed brewing unit of the beverage machine of figure 1 in a "capsule closure mode";
- Figure 4a is a detailed view of a capsule positioner of the beverage machine of figure 1, in a closed position, according to a first embodiment;
- Figure 4b is a detailed view of a capsule positioner of the beverage machine of figure 1, in an open position, , according to a first embodiment;
- Figure 5 is a schema of interactions between a capsule according to an embodiment, a programming device according to an embodiment, and a beverage preparation machine according to an embodiment;
- Figures 6a, 6b, 6c show screen captures of a user-interface of programming device according to an embodiment.

### Detailed description of the invention

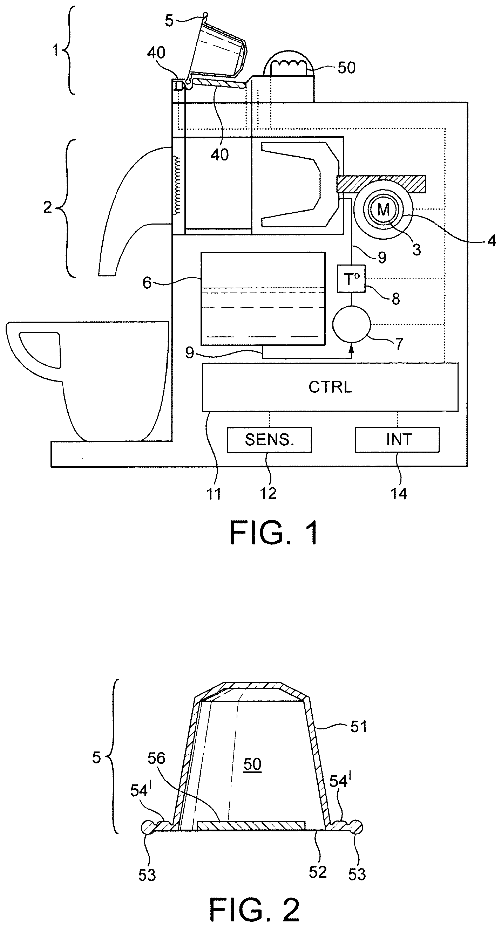

A beverage machine **1** according to an embodiment is illustrated schematically on figure 1. The beverage machine comprises a brewing unit **2** which is coupled with an electrical motor **3** driving transmission means **4** for moving the brewing unit between an opened and a closed position. The brewing unit is represented in the opened position on figure 1. The brewing unit allows the preparation of a beverage from a capsule **5** containing at least one ingredient, e.g. ground coffee or tea or chocolate.

As shown in Figure 2, the capsule has a generally cup-shaped body **51** and a covering membrane **52.** Membrane is assembled to cup along a peripheral rim **54** of cup. The rim may be covered with a seal **54',** e.g. made of elastomeric or plastic material. Furthermore, the capsule in particular the rim and/or the membrane may bear a ring or toroid **53,** e.g. for assisting manufacturing and/or handling of the capsule. Such capsule forms a packaging for containing an ingredient **50,** e.g. ground coffee, of a beverage to be prepared with the beverage preparation machine. In an embodiment, the capsule forms a gastight packaging, e.g. made of aluminium or an aluminium-alloy. Alternatively, the capsule may be more or less pervious, e.g. perforated and/or made of organic, in particular plastic material, e.g. biodegradable material. The capsule's cup and/or the capsule's membrane may be made of a monolithic material, e.g. a metallic material or a conductive ceramic and/or conducive organic material, or may be made of a structure covered or containing a conductive material, e.g. a conductive coating or track, e.g. an aluminium, iron and/or copper coating or track. The capsule comprises a storage 56 provided with a memory adapted to be readable and writable, at least once. The memory is configured to store information provided by a user. The storage 56 comprises a capsule communication interface adapted to allow a programming arrangement to access the memory, more particularly to read and/or write its content.

In a specific embodiment of the storage, the communication interface allows wireless communications. Typically, the storage 56 may be a RFID tag or rim having a read/write mode in which a memory can be written or read by a RFID reader. In particular, the RFID rim may contain an antenna disposed on the rim of the capsule, and coupled to a readable/writable memory.

As represented on Figure 1, water supply means are also provided as a part of the machine, such means including a water reservoir **6,** a water pump **7** and a water heater **8.** Water circulates in a water circuit **9** which is linked to the brewing unit. Controller is also provided in the machine. The controller includes typically a control unit **11,** sensors **12** and a user interface **13.** The control unit includes processor(s), memories and programs enabling to provide appropriate inputs to and receive outputs from the different activation means of the machine in particular, the pump, heater, motor and user interface.

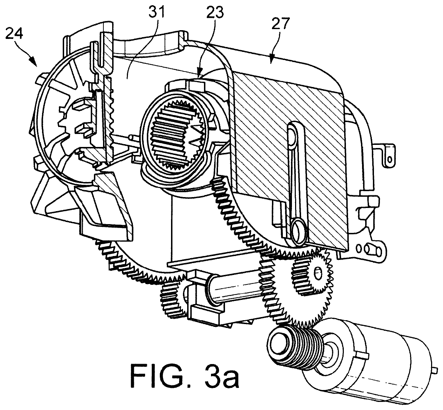

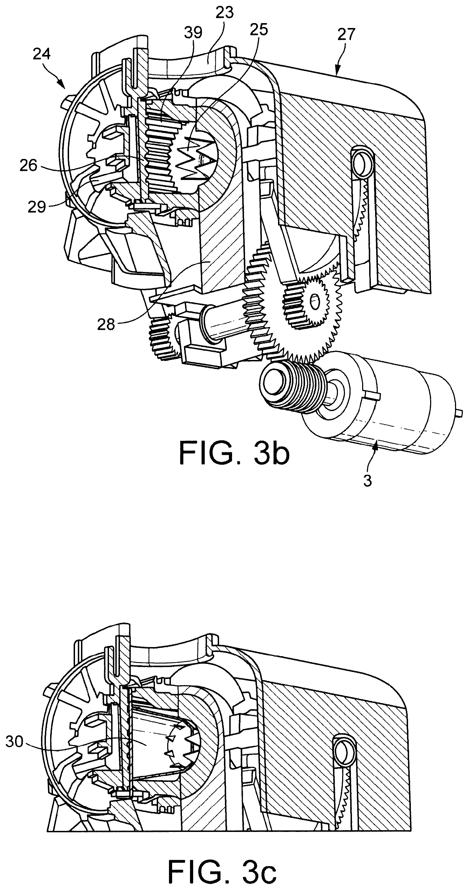

Referring now to figures **3a****,** **3b,** and **3c****,** there is shown therein an exemplary motorized embodiment of the brewing unit. The brewing unit more particularly comprises a first assembly **23** and a second assembly **24** which are movable relatively one another. In this particular mode, the rear injection assembly 23 represents the capsule cage including injection blades **25.** The front assembly **24** represents the beverage delivery assembly and includes a capsule delivery plate **26.** The front assembly is associated to an outer casing **27** and the whole is movable relatively to the rear injection assembly **23** which remains fixed to a frame **28.** The front delivery assembly **24** comprises a beverage outlet **29.** The front delivery assembly **24** is moved relatively to the rear injection assembly **23** by means of the motor **3** which drives the transmission means **4.** In the opened position (figure 3b), a passage **31** is provided between the first and second assemblies **23, 24** for allowing the insertion of a capsule. In the closed position (figure **3c**), a brewing chamber **39** is provided.

The beverage machine further comprises a capsule positioner **40** having a seat adapted to store at least one first capsule out of the brewing chamber, and preferably outside the brewing unit. In an embodiment, the positioner is arranged to store at least a second capsule, out of the brewing chamber, and preferably outside the brewing unit. The capsule positioner may comprise a closing apparatus operable for switching the capsule holder between at least an opened position and a closed position. In the closed position, the capsule holder is configured to store the capsule in the seat. In the opened position, the capsule holder is configured to allow a capsule, pre-positioned into the capsule seat, entering the brewing unit chamber. More particularly, the capsule positioner is arranged so as to allow a capsule entering and passing through the passage of the brewing unit before reaching the capsule chamber, when the capsule positioner is set in its opened position. The capsule may be transferred from the capsule positioner in the opened position to the brewing unit by transfer means such guiding means, motorized elements, moving parts, actuators and/or any other means adapted to move the capsule out of the seat to the brewing unit, and in particular to the brewing unit chamber. Advantageously, the closing apparatus is arranged to close at least partially the passage when the capsule positioner is in its closed position, notably in order to prevent the unsafe entry of an unexpected object into the brewing unit.

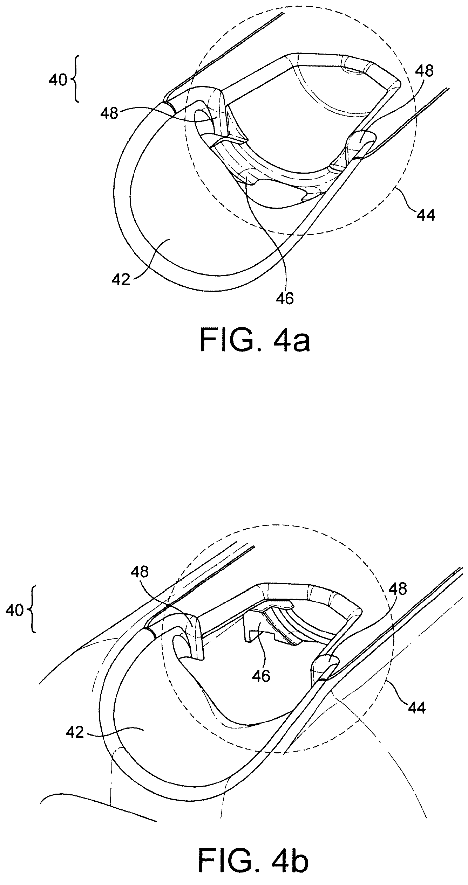

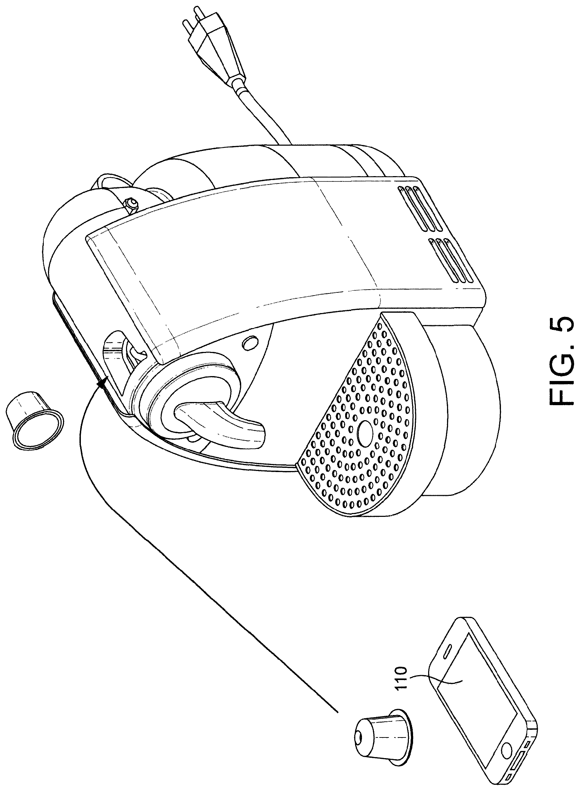

In a first embodiment, as shown in figures **4a** and **4b****,** the capsule seat **44** is formed in a housing **42** that may be integrated to the housing of the beverage machine as shown on Figures **4****,** **5****.** Alternatively, the capsule seat may be a separate part mounted on the housing of the beverage machine (not represented on the drawings). The capsule seat may comprise guides 48 formed into the housing 42 and surrounding the capsule seat, in particular to ease the positioning of a capsule by a user when the capsule positioner is in the closed position, and/or to improve the holding of a capsule in the seat. Moreover, the guides may be arranged to guide the movement of the capsule when the capsule positioner is switched to its opened position, and to prevent a capsule inserted into the seat to be translated with the closing apparatus, for example when the capsule holder is switched from the closed to the opened position.

In the first embodiment, for switching the capsule positioner between the opened and closed positions, the closing apparatus **46** may be driven by a motorized arrangement, controlled for example by the control unit **11** or by an additional controller. Alternatively, the closing apparatus may be mechanically linked by a mechanical coupling means with the brewing unit, and in particular with the first assembly **23** and/or the second assembly **24,** so as to switch between the opened and closed positions depending on whether the brewing unit is opened or closed. For instance, the mechanical coupling means may be arranged to open the closing apparatus when the brewing unit is in the opened position, and to close the closing apparatus otherwise. In an embodiment, the closing apparatus may be rigidly fixed to a part of the brewing unit or be formed by a part of the brewing unit, in particular by the first assembly **23** and/or the second assembly **24.** The capsule holder housing comprises an opening large enough to let a capsule pass through it. In particular the outlines of said opening may reproduce sensibly the outlines of a longitudinal cross section profile of a capsule. When the capsule positioner is closed, as illustrated on Figure **4a****,** the base of the capsule seat is formed by the closing apparatus. When the capsule positioner is opened, as illustrated on Figure **4b****,** the closing apparatus is configured to authorize a capsule positioned onto the capsule seat **44** to leave the capsule seat. In particular, the capsule positioner **40** is positioned on the upper part of the housing of the beverage machine to let a capsule falling into the passage 31 under the action of the gravity force, when the capsule positioner is opened.

In the first embodiment, the closing apparatus **46** may be included in the capsule seat and forms part of it. More particularly, the closing apparatus may comprise a sliding cover inserted into lateral guides of the housing. The shape of the sliding cover may comprise an area with a recess having sensibly the outside shape of a part of the capsule. The sliding cover may be translated, along one longitudinal axis defined by the configuration of the lateral guides, to switch the positioner between its opened and closed positions. The translation of the sliding cover may be performed using a motorized arrangement (not represented), and/or with the help of mechanical coupling means (not represented) linked with the first and/or the second assembly of the brewing unit (not represented), and/or may be part of the first or the second assembly of the brewing unit itself (not represented).

As illustrated on Figure 1, the beverage machine comprises a machine communication interface 50. The machine communication interface 50 is adapted to communicate with the capsule communication interface of a capsule positioned in the vicinity of the machine, and/or onto the capsule seat and/or passing through the capsule seat and/or into the brewing unit 2. In particular, the machine communication interface 50 may be an RFID reader adapted to communicate with the RFID interface comprised in the storage 56 of a capsule. The machine communication interface 50 is configured to read the content of the memory of the storage 56 of a capsule, and more particularly information provided by a user stored in the storage 56.. In an embodiment, the machine is configured to store information read from the storage 56 so as to use the same information if the same type of capsule (e.g. blend) is inserted again. This allows the user to program each type (e.g. blend) only once.

An example of interaction between the machine and a capsule with the storage 50 is described hereafter. The machine is initially in a state S₁ in which the capsule positioner is closed. In this state S₁, a capsule cannot enter the brewing chamber through the capsule positioner. In the state S₁, the machine communication interface 50 is switched on. During a first step, the machine communication interface 50 is used to watch over the capsule seat, so as to detect a presence of a capsule provided with the storage 50, in the vicinity of the machine or onto the capsule seat. The first step is carried out repeatedly, until a capsule with the storage 50 is actually detected. During a second step, the content C of memory of the storage 50 of the detected capsule is read. In a third optional step, a current status S of the machine is determined, read or accessed by the controller 10. In particular, the current status S may include at least one or a combination of parameters related to items included in the following non exhaustive list: the presence of a capsule into the brewing chamber or in the cage of the brewing chamber, the completion state of a beverage preparation process, the current availability of the different components of the machine, the level of water into the water tank, the readiness of the thermo-block. In a fourth step, a sequence SEQ of actions is determined or chosen. If a capsule with the storage 50 has been detected during the first step, the sequence SEQ comprises at least an action related to the content C of the memory of the storage 50 read during the second step. For instance, the content C may comprise an information related to a user-defined volume of beverage to prepare for this specific capsule. Hence, the sequence SEQ may comprise an action to set the capsule holder into its opened position, and an action to start automatically the preparation of the user-defined volume of beverage when the detected capsule has reached the brewing unit chamber. In a fifth step, each action of the sequence SEQ is actually performed by the beverage preparation machine. In an exemplary embodiment, if a capsule with the storage 50 has been detected, the sequence SEQ comprises an action to open the brewing unit if necessary, an action to switch the capsule holder to its opened position, an action to close the brewing unit if necessary as soon as the capsule has entered the brewing chamber, and an action to start the beverage preparation process according to the content C of the memory of the storage 50. The user has consequently only to put a user-programmed capsule into the capsule holder to start automatically the preparation of a beverage. No other user interaction, like pressing a button for example, is needed anymore. Moreover, only the detection of a programmed capsule with the storage 50 may trigger the execution of this sequence SEQ, enhancing both the safety level and the ergonomic of the beverage machine. The sequence SEQ may also be determined by taking into consideration the current status S of the machine. The current status S may be analyzed to determine whether the machine is ready and/or capable of preparing a beverage with the detected capsule.

A programming device 110 according to an embodiment is illustrated schematically on figure 5. The programming device 110 comprises a communication interface adapted to communicate with the capsule communication interface of a capsule positioned in the vicinity of the programming device 110. In particular, the communication interface of the programming device may be an RFID reader adapted to communicate with the RFID interface comprised in the storage 56 of a capsule. The communication interface comprises means for writing information in the memory of the storage 56 of a capsule, and more particularly information provided by a user through a user-interface of the programming device 110.

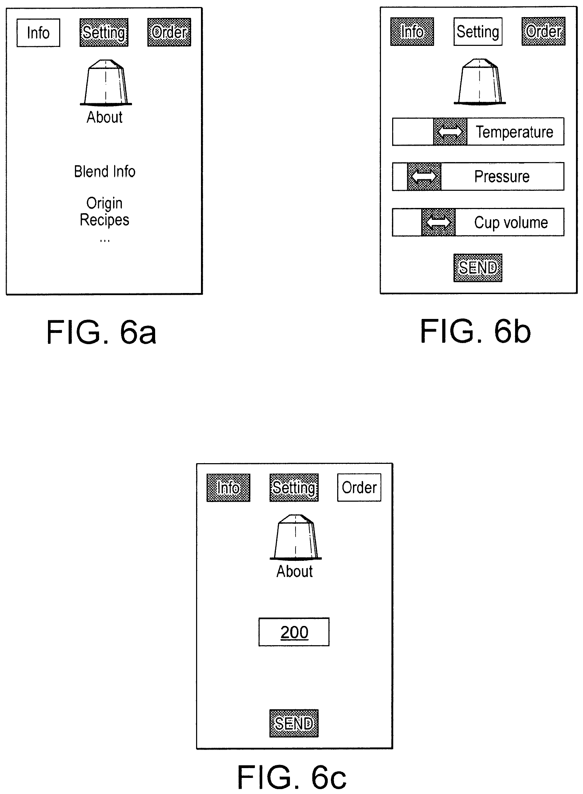

An embodiment of the user interface is shown on Figures 6a, 6b, 6c. The figures represent screen captures of a user-interface displayed when the capsule communication interface of a capsule provided with the storage 56 are coupled to the communication interface of the programming device 110.

In an embodiment, as illustrated on figures 6, the programming device 110 is a common standard device, such a smart phone or a tablet computer with an appropriate communication interface to be coupled to the capsule communication interface. In particular, the programming device 110 may be an RFID enabled smart phone.

As shown on Figure 6a, in an embodiment, the programming device 110 comprises recognition means for identifying capsule. The programming device 110 may then display in an info panel information related to the identified capsule.

As shown on Figure 6b, in an embodiment, the programming device 110 comprises a user-interface for a user to enter user-defined parameters to be attached to the capsule currently coupled to the programming device. For instance, a user may set a plurality of parameters by using a dedicated setting panel. In the example of figure 6b, the user may define, for the coupled capsule, parameters that will be used by a machine according to the invention for preparing a beverage. In particular, the user may choose a temperature, and/or a pressure, and/or a cup volume. Default parameters proposed in the setting panel may be chosen according to identification information provided by the recognition means. The default parameters proposed in the setting panel may also be chosen according to user preferences stored in the programming device 110. The user-defined parameters are then send to the capsule communication interface, through the communication interface of the programming device, and are written in the memory of the storage 56. The sending of the user-defined parameters may be performed when the user presses a dedicated button, "send" button as illustrated on figure 6b, or automatically by the programming device 110. After the completion of the transmission of the user-defined parameters, the capsule can be freely taken away from the vicinity of the programming device. In particular, the user can store the capsule for a given period, or can use the capsule directly after these programming steps for preparing a beverage with the beverage dispensing machine.

A series of typical use cases of the machine according to the embodiments will now be discussed.

### Example 1

In this example, a single portioned capsule with an RFID tag including a readable/writable memory for storing user-defined parameters is used in combination with a RFID enabled smartphone allowing the user entering user-defined parameters. A corresponding dispensing machine with a RFID interface for reading user-defined parameters stored in the RFID tag of the capsule is also used. The dispensing machine is configured to dispense a beverage according to the user-defined parameters stored in the capsule. In this example, the dispensing machine has for example a cup detection means, and is fully automatic, without necessarily specific user interface for entering user-defined parameters. Once the cup is placed and the capsule programmed with the user-defined parameters is inserted, the dispensing is starting automatically the preparation of the beverage without any interaction between the user and the dispensing machine.

In this example, in a first step, the user is programming a capsule according to the invention via an application of its smart-phone, for example by entering a volume of beverage to prepare with said capsule. In a second step, the user inserts said capsule into the beverage dispensing machine: the machine then reads the user-defined parameters stored in the capsule and starts automatically the preparation of the beverage, for example, once a cup is positioned to receive the beverage.

### Example 2

In this example, a single portioned capsule with a contactless chip including a readable/writable memory for storing user-defined parameters is used in combination with a programming device having means for identifying a user or means for storing user preferences. The user-preferences are entered by the user and stored during a preliminary configuration step. After the preliminary configuration, the user programs each capsule according to the invention by positioning each one at the vicinity of the programming device. A corresponding dispensing machine with a reader for reading user-defined parameters stored in the contactless chip of the capsule is also used. The dispensing machine is configured to dispense a beverage according to the user-defined parameters stored in the capsule.

### Example 3

In this example, a single portioned capsule with a readable/writable memory for storing user-defined parameters is used. A dedicated programming interface is used to allow the user entering user-defined parameters, such as a choice of recipe to use, and the use of additional ingredients (for example milk, sugar, aroma,... that the machine is capable to deliver). The programming steps are performed by placing the storage 56 of the capsule in contact with a dedicated surface of the programming device. The dispensing machine is configured to read the user-defined parameters and to display and set by default said parameters on the user-interface of the machine. The user can then trigger the preparation process using said parameters or modify its choices using the machine interface.

### Example 4

In this example, in a first step, the user is programming a capsule according to the invention via a programming device. In a second step, the user inserts said capsule into the beverage dispensing machine: the machine then identify a type for said capsule, and reads the user-defined parameters stored in said capsule. The dispensing machine stores the user-defined parameters read from said capsule. The dispensing machine is configured to use said user-defined parameters each time a capsule of this type without any user-defined parameter is introduced in the machine. The dispensing machine may be reconfigured to store and use new user-defined parameters if a capsule of the same type with new user-defined parameters is introduced in the machine.

## Claims

1. A combination of an end-user programming device (110) for programming by a user of a beverage producing device (1) a capsule (5) to deliver a beverage in the beverage producing device (1) and a capsule (5), which capsule (5) comprises:
- a storage (56) having a memory space storing information related to preferences of the user of the beverage producing device (1);
- a capsule communication interface configured to:
∘ write in the memory space the information related to the preferences of the user, received on the capsule communication interface; and,
∘ allow the reading of the information stored in the memory space,
the programming device (110) comprising:
- a preferences manager for accessing preferences provided by the user of the beverage producing device (1); and
- a communication interface of the programming device (110) configured, when coupled with the capsule communication interface of said capsule (5), to send to the capsule communication interface the preferences provided by the user of the beverage producing device (1).

2. The combination according to claim 1 **characterized in that** the programming device (110) comprises a user-interface for the user to enter the preferences.

3. The combination according to claim 1 or 2 **characterized in that** the programming device comprises a user-interface for the user to select the preferences.

4. The combination according to any one of claims 1, 2 or 3, **characterized in that** the programming device (110) comprises an identification means for identifying the user, and for setting the preferences according to the identity of the user.

5. A beverage preparation system comprising the combination according to any of claims 1 - 4 and a beverage preparation machine (1) having an ingredient processing module (2) for preparing a beverage with at least one ingredient supplied with said capsule (5) storing user preference information, the machine comprising a reader having a machine communication interface (50) configured, when coupled with the capsule communication interface of the capsule (5), to read, through the capsule communication interface, the user preference information stored in the memory space of said capsule (5), the ingredient processing module (2) being configured to prepare the beverage according to the read user preference information.

6. The system according to claim 5, comprising a positioner (40, 80) arranged to hold said capsule (5), a sensing arrangement (50) adapted to detect an event related to the insertion by a user of said capsule (5) on or into the positioner(40, 80); the machine (1) being configured, upon detection of the event, to transfer said capsule (5) to the ingredient processing module (2) by using transfer means (46, 48; 83, 85), and then to start the preparation of the beverage.

7. The system according to claim 5 or 6, comprising a or said positioner (40, 80) arranged to hold said capsule (5), a sensing arrangement adapted to detect an event related to the presence of said capsule on or into the positioner; the machine being configured, upon detection of the event, to transfer said capsule (5) to the ingredient processing module (2) by using transfer means (46, 48; 83, 85), and then to start the preparation of the beverage.

8. The system according to any one of claims 5 to 7, wherein the ingredient processing module (2) comprises a first part (23) and a second part (24) which are movable relatively one another, said processing module (2) being configurable into an opened position wherein a passage (31) is provided between the first and second part (23; 24) for allowing the insertion of a capsule (5); the machine further comprising closing means (46; 86) arranged to close at least partially the passage (31); the machine (1) being further configured to operate the closing means (46; 86) so as to open the passage (31) upon the detection of the event.

9. The system according to any of claims 5 - 8, wherein the ingredient processing module (2) is configured to prepare the beverage according to default parameters if the information stored in the memory space of said capsule (5) cannot be read or are empty, corrupted or not usable by the machine (1).

10. A method of using the programming device (110) of the combination according to any of claims 1 - 4 to store information on said capsule (5), the method comprising a user entering and/or selecting information related to preferences of the user on the programing device (110), transferring said information from the programing device (110) to the capsule (5).

## Patentansprüche

1. Kombination aus einer Endbenutzer-Programmiervorrichtung (110) zum Programmieren durch einen Benutzer einer Getränkeherstellungsvorrichtung (1) einer Kapsel (5) zur Abgabe eines Getränks in die Getränkeherstellungsvorrichtung (1) und einer Kapsel (5), wobei die Kapsel (5) Folgendes umfasst:
- einen Speicher (56) mit einem Speicherplatz, der Informationen speichert, die sich auf Präferenzen des Benutzers der Getränkeherstellungsvorrichtung (1) beziehen;
- eine Kapsel-Kommunikationsschnittstelle, die für Folgendes konfiguriert ist:
o Schreiben der Informationen in den Speicherplatz, die sich auf die Präferenzen des Benutzers beziehen, die auf der Kapsel-Kommunikationsschnittstelle empfangen werden; und,
o Zulassen des Lesens der im Speicherplatz gespeicherten Informationen, wobei die Programmiervorrichtung (110) Folgendes umfasst:
- einen Präferenzmanager für den Zugriff auf Präferenzen, die vom Benutzer der Getränkeherstellungsvorrichtung (1) bereitgestellt werden; und
- eine Kommunikationsschnittstelle der Programmiervorrichtung (110), die so konfiguriert ist, dass sie, wenn sie mit der Kapsel-Kommunikationsschnittstelle der Kapsel (5) gekoppelt ist, die vom Benutzer der Getränkeherstellungsvorrichtung (1) bereitgestellten Präferenzen an die Kapsel-Kommunikationsschnittstelle sendet.

2. Kombination nach Anspruch 1, **dadurch gekennzeichnet, dass** die Programmiervorrichtung (110) eine Benutzerschnittstelle umfasst, über die der Benutzer die Präferenzen eingeben kann.

3. Kombination nach Anspruch 1 oder 2, **dadurch gekennzeichnet, dass** die Programmiervorrichtung eine Benutzerschnittstelle für den Benutzer zum Auswählen der Präferenzen umfasst.

4. Kombination nach einem der Ansprüche 1, 2 oder 3, **dadurch gekennzeichnet, dass** die Programmiervorrichtung (110) ein Identifizierungsmittel zum Identifizieren des Benutzers und zum Einstellen der Präferenzen gemäß der Identität des Benutzers umfasst.

5. Getränkezubereitungssystem, umfassend die Kombination nach einem der Ansprüche 1 bis 4 und eine Getränkezubereitungsmaschine (1) mit einem Zutatenverarbeitungsmodul (2) zum Zubereiten eines Getränks mit mindestens einer Zutat, die mit der Kapsel (5) geliefert wird, die die Präferenzinformationen des Benutzers speichert, wobei die Maschine ein Lesegerät mit einer Maschinenkommunikationsschnittstelle (50) umfasst, die konfiguriert ist, wenn sie mit der Kapsel-Kommunikationsschnittstelle der Kapsel (5) gekoppelt ist, die über die Kapsel-Kommunikationsschnittstelle in dem Speicherplatz der Kapsel (5) gespeicherten Präferenzinformationen zu lesen, wobei das Zutatenverarbeitungsmodul (2) konfiguriert ist, um das Getränk gemäß den gelesenen Benutzerpräferenzinformationen zuzubereiten.

6. System nach Anspruch 5, umfassend einen Positionierer (40, 80), der angeordnet ist, um die Kapsel (5) zu halten, eine Erfassungsanordnung (50), die dazu eingerichtet ist, ein Ereignis zu erfassen, das mit dem Einschieben der Kapsel (5) durch einen Benutzer an oder in den Positionierer (40, 80) zusammenhängt; wobei die Maschine (1) konfiguriert ist, beim Erfassung des Ereignisses, die Kapsel (5) unter Verwendung einer Übertragungseinrichtung (46, 48; 83, 85) an das Zutatenverarbeitungsmodul (2) zu übertragen und dann mit der Zubereitung des Getränks beginnen.

7. System nach Anspruch 5 oder 6, umfassend einen oder den Positionierer (40, 80), der angeordnet ist, um die Kapsel (5) zu halten, eine Erfassungsvorrichtung, die ausgebildet ist, um ein Ereignis in Bezug auf das Vorhandensein der Kapsel am oder in dem Positionierer zu erfassen; wobei die Maschine konfiguriert ist, beim Erfassen des Ereignisses, die Kapsel (5) unter Verwendung einer Übertragungseinrichtung (46, 48; 83, 85) an das Zutatenverarbeitungsmodul (2) zu übertragen und dann mit der Zubereitung des Getränks beginnen.

8. System nach einem der Ansprüche 5 bis 7, wobei das Zutatenverarbeitungsmodul (2) einen ersten Teil (23) und einen zweiten Teil (24) umfasst, die relativ zueinander bewegbar sind, wobei das Verarbeitungsmodul (2) in eine geöffnete Position konfigurierbar ist, in der ein Durchgang (31) zwischen dem ersten und dem zweiten Teil (23; 24) bereitgestellt wird, welches das Einführen einer Kapsel (5) ermöglicht; wobei die Maschine ferner Schließmittel (46; 86) umfasst, die angeordnet sind, um den Durchgang (31) zumindest teilweise zu schließen; wobei die Maschine (1) ferner konfiguriert ist, die Schließmittel (46; 86) zu bedienen, um den Durchgang (31) bei der Erfassung des Ereignisses zu öffnen.

9. System nach einem der Ansprüche 5 bis 8, wobei das Zutatenverarbeitungsmodul (2) so konfiguriert ist, dass es das Getränk gemäß Standardparametern vorbereitet, wenn die im Speicherplatz der Kapsel (5) gespeicherten Informationen nicht gelesen werden können oder leer sind, beschädigt oder nicht von der Maschine verwendbar (1) sind.

10. Verfahren zur Verwendung der Programmiervorrichtung (110) der Kombination nach einem der Ansprüche 1 bis 4 zum Speichern von Informationen in der Kapsel (5), wobei das Verfahren einen Benutzer umfasst, der Informationen bezüglich der Präferenzen des Benutzers auf der Programmiervorrichtung (110) eingibt und/oder auswählt, wobei die Informationen von der Programmiervorrichtung (110) zur Kapsel (5) übertragen werden.

## Revendications

1. Combinaison d'un dispositif de programmation d'utilisateur final (110) pour la programmation par un utilisateur d'un dispositif de production de boisson (1) d'une capsule (5) pour délivrer une boisson dans le dispositif de production de boisson (1) et d'une capsule (5), laquelle capsule (5) comprend :
- un stockage (56) ayant un espace mémoire stockant des informations relatives aux préférences de l'utilisateur du dispositif de production de boisson (1) ;
- une interface de communication de capsule configurée pour :
∘ écrire dans l'espace mémoire les informations relatives aux préférences de l'utilisateur, reçues à travers l'interface de communication de capsule ; et,
∘ permettre la lecture des informations stockées dans l'espace mémoire, le dispositif de programmation (110) comprenant :
- un gestionnaire de préférences pour accéder aux préférences fournies par l'utilisateur du dispositif de production de boisson (1) ; et
- une interface de communication du dispositif de programmation (110) configurée, lorsqu'elle est couplée à l'interface de communication de capsule de ladite capsule (5), pour envoyer à l'interface de communication de capsule les préférences fournies par l'utilisateur du dispositif de production de boisson (1).

2. Combinaison selon la revendication 1, **caractérisée en ce que** le dispositif de programmation (110) comprend une interface utilisateur pour que l'utilisateur entre les préférences.

3. Combinaison selon la revendication 1 ou 2, **caractérisée en ce que le** dispositif de programmation comprend une interface utilisateur pour que l'utilisateur sélectionne les préférences.

4. Combinaison selon l'une quelconque des revendications 1, 2 ou 3, **caractérisée en ce que** le dispositif de programmation (110) comprend un moyen d'identification pour identifier l'utilisateur et pour régler les préférences en fonction de l'identité de l'utilisateur.

5. Système de préparation de boisson comprenant la combinaison selon l'une quelconque des revendications 1 à 4 et une machine de préparation de boisson (1) ayant un module de traitement d'ingrédients (2) pour préparer une boisson avec au moins un ingrédient fourni avec ladite capsule (5) stockant les informations de préférence d'utilisateur, la machine comprenant un lecteur ayant une interface de communication machine (50) configurée, lorsqu'elle est couplée à l'interface de communication de capsule de la capsule (5), pour lire, via l'interface de communication de capsule, les informations de préférence d'utilisateur stockées dans l'espace mémoire de ladite capsule (5), le module de traitement d'ingrédients (2) étant configuré pour préparer la boisson en fonction des informations de préférence d'utilisateur lues.

6. Système selon la revendication 5, comprenant un dispositif de positionnement (40, 80) agencé pour maintenir ladite capsule (5), un agencement de détection (50) adapté pour détecter un événement lié à l'insertion par un utilisateur de ladite capsule (5) sur ou dans le dispositif de positionnement (40, 80) ; la machine (1) étant configurée, lors de la détection de l'événement, pour transférer ladite capsule (5) vers le module de traitement d'ingrédients (2) en utilisant les moyens de transfert (46, 48 ; 83, 85) puis pour démarrer la préparation de la boisson.

7. Système selon la revendication 5 ou 6, comprenant un ou ledit dispositif de positionnement (40, 80) agencé pour maintenir ladite capsule (5), un agencement de détection adapté pour détecter un événement lié à la présence de ladite capsule sur ou dans le dispositif de positionnement ; la machine étant configurée, lors de la détection de l'événement, pour transférer ladite capsule (5) vers le module de traitement d'ingrédients (2) en utilisant les moyens de transfert (46, 48 ; 83, 85) puis pour démarrer la préparation de la boisson.

8. Système selon l'une quelconque des revendications 5 à 7, dans lequel le module de traitement d'ingrédients (2) comprend une première partie (23) et une seconde partie (24) qui sont mobiles l'une par rapport à l'autre, ledit module de traitement (2) pouvant être configuré dans une position ouverte, dans laquelle un passage (31) est fourni entre les première et seconde parties (23 ; 24) pour permettre l'insertion d'une capsule (5) ; la machine comprenant en outre des moyens de fermeture (46 ; 86) disposés pour fermer au moins partiellement le passage (31) ; la machine (1) étant en outre configurée pour faire fonctionner les moyens de fermeture (46 ; 86) de manière à ouvrir le passage (31) lors de la détection de l'événement.

9. Système selon l'une quelconque des revendications 5 à 8, dans lequel le module de traitement d'ingrédients (2) est configuré pour préparer la boisson selon des paramètres par défaut si les informations stockées dans l'espace mémoire de ladite capsule (5) ne peuvent pas être lues, sont vides, corrompues ou non utilisables par la machine (1).

10. Procédé d'utilisation du dispositif de programmation (110) de la combinaison selon l'une quelconque des revendications 1 à 4 pour stocker des informations sur ladite capsule (5), le procédé comprenant un utilisateur entrant et/ou sélectionnant des informations relatives aux préférences de l'utilisateur sur le dispositif de programmation (110), transférant lesdites informations du dispositif de programmation (110) à la capsule (5).
